# EUROPÄISCHE PATENTANMELDUNG

(11) **EP 1 249 750 A1**
(43) Veröffentlichungstag der Anmeldung: **16.10.2002**
(21) Anmeldenummer: 01109194.9
(22) Anmeldetag: 12.04.2001
(51) Int. Cl.: G06F 1/00, H05K 7/00, H05K 7/20

(54) **Einschubrahmen**

(71) Anmelder: Lufthansa Technik AG, 22335 Hamburg (DE)
(72) Erfinder: Muirhead, Andrew, 22846 Norderstedt (DE); Starke, Henry, 25474 Ellerbek (DE)
(74) Vertreter: Glawe, Delfs, Moll & Partner

(57) **Zusammenfassung**

Ein Einschubrahmen für Flugzeuge besteht aus einem Satz von Bauteilen, umfassend Rahmenteile, nämlich Bodenteile (1), Deckenteile (2), Seitenteile (3) und Rückenteile (4), und erste elektrische Steckverbinder. Dieser Satz läßt sich erfindungsgemäß zu einem einheitlichen derartigen Einschubrahmen lösbar verbinden, wobei die Breite mindestens eines Teils der Bodenteile (1), Deckenteile (2) und/oder Rückenteile (4) jeweils der Breite eines Einschubfachs entspricht, die Höhe mindestens eines Teils der Rückenteile (4) jeweils der Höhe eines Einschubfachs entspricht und die Rückenteile (4) jeweils zur Verbindung mit dem oder den entsprechenden ersten Steckverbindern eigerichtet sind.

## Beschreibung

Die Erfindung betrifft einen Einschubrahmen für Flugzeuge, der eine oder mehrere übereinanderliegende Reihen mit jeweils einem oder mehreren nebeneinanderliegenden Einschubfächern zur Aufnahme von Elektronikeinheiten aufweist, wobei ein Einschubfach zum unabhängigen Einschieben bzw. Ausziehen einer Elektronikeinheit eingerichtet ist. Einem Einschubfach ist jeweils ein erster elektrischer Steckverbinder so zugeordnet, daß ein Zusammenwirken des ersten Steckverbinders mit einem entsprechendem zweiten Steckverbinder einer Elektronikeinheit allein infolge des Einschiebens der Elektronikeinheit in das Einschubfach bewirkbar ist.

Ein derartiger Einschubrahmen ist bspw. im sog. E/E-Bereich des Flugzeugs unterhalb des Cockpits vorgesehen und dient zur Aufnahme von Elektronikeinheiten (sog. LRUs, line replaceable units). Für die Elektronikeinheiten und die Einschubrahmen existieren eine Reihe von Spezifikationen (bspw. ARINC, Lufthansa Technik XXL). Es ist bekannt, den ersten elektrischen Steckverbinder an einem L-förmigen Bauteil, dem sogenannten Tray, vorzusehen, wobei das Tray aus einem Boden- und einem Rückenteil gebildet ist. Der erste Steckverbinder ist Teil eines in der Rückwand eingelassenen Adapters. Das Tray ist im Gebrauch fest mit dem Boden eines Einschubfachs des Einschubrahmens verbunden. Der Adapter ist rückseitig mit den entsprechenden Anschlußleitungen verbunden. Der Innenraum des Trays, d. h. das durch die L-Form definierte quaderförmige Volumen, ist zur Aufnahme einer Elektronikeinheit eingerichtet. Diese weist an ihrer Rückseite einen entsprechenden zweiten Steckverbinder auf. Der erste Steckverbinder ist so angeordnet, daß die elektrische Verbindung allein infolge des Einschiebens der Elektronikeinheit in das Einschubfach bewirkt wird, ohne daß ein zusätzlicher Handgriff erforderlich ist. Auf diese Weise wird ein schnellstmögliches Auswechseln der Elektronikeinheiten ermöglicht. Die Elektronikeinheiten werden mit Arretiereinrichtungen (sogenannte Hold-downs) im Einschubrahmen gehalten. Die Ausführung des Trays als separates Bauteil ermöglicht es, dieses mit dem Adapter vom Einschubrahmen zu trennen und das Tray gegen ein anderes auszutauschen. Dies kann bspw. erforderlich sein, wenn der Adapter defekt ist.

Ein Einschubrahmen des Standes der Technik ist an den jeweiligen Flugzeugtyp sowie an den jeweiligen Einbauort im Flugzeug individuell angepaßt. Dies ist arbeitsaufwendig und erfordert die Vorhaltung einer großen Anzahl von Teilen.

Aufgabe der Erfindung ist es, den Aufwand zur Herstellung von derartigen Einbaurahmen zu reduzieren und/oder die Zahl der vorzuhaltenden Teile zu reduzieren.

Die Erfindung schlägt zu diesem Zweck einen Satz von Bauteilen, umfassend im wesentlichen flache Rahmenteile, nämlich Boden-, Decken-, Seiten- und Rückenteile, und erste elektrische Steckverbinder, vor, die sich zu einem einheitlichen Einschubrahmen lösbar verbinden lassen, wobei die Breite mindestens eines Teils der Boden-, Decken- und/oder Rückenteile jeweils der Breite eines Einschubfachs entspricht, die Höhe mindestens eines Teils der Rückenteile jeweils der Höhe eines Einschubfachs entspricht und die Rückenteile jeweils zur Verbindung mit dem oder den entsprechenden ersten Steckverbindern eingerichtet sind.

Zunächst werden einige der verwendeten Begriffe erläutert.

Die Begriffe Elektronikeinheit und (Elektronik-)Einschub werden synonym verwendet.

Die Breiten der Elektronikeinheiten sind im internationalen Luftverkehr standardisiert und entsprechen den in Anspruch 12 tabellierten Standardbreiten, die gewöhnlich in Einheiten von ATR oder MCU angegeben werden. Diese Einheiten liegen jeweils nicht exakt fest, sondern nur innerhalb gewisser Schwankungsbreiten. Zudem ist die ATR/MCU-Skala nicht linear. Die Höhe der Elektronikeinheiten liegt im allgemeinen fest, wobei jedoch sowohl Einschübe mit Über- als auch solche mit Unterhöhe gegenüber der Standardhöhe vorkommen. Die Tiefe der Einschübe liegt im allgemeinen fest, wobei jedoch ebenfalls abweichende Maße vorkommen. Die Erfindung ist nicht auf Elektronikeinheiten mit einer einzigen Höhe und/oder Breite festgelegt.

Ein Satz von Bauteilen ist grundsätzlich eine Menge von Bauteilen, mit Hilfe derer sich ein erfindungsgemäßer Einschubrahmen bilden läßt. Auch ein nicht in diesem Sinne vollständiger Satz von Bauteilen ist von der Erfindung umfaßt, falls seine erfindungsgemäße Verwendung feststeht. "Übereinander liegend" bzw. "nebeneinander liegend" ist nicht so zu verstehen, daß ein Einschubrahmen mindestens zwei (horizontale) Reihen von Einschubfächern umfassen muß oder jede Reihe mindestens zwei Einschubfächer aufweisen muß. Die Erfindung umfaßt bspw. auch einen Einschubrahmen mit lediglich einer Reihe von Einschubfächern (sog. shelf). Im allgemeinen wird es sich um einen Einschubrahmen mit mindestens zwei, vorzugsweise mindestens drei miteinander zu verbindenden Reihen von Einschubfächern handeln. Die Begriffe "übereinander liegend" und "nebeneinander liegend" sollen andeuten, daß ein Einschubrahmen im allgemeinen einen matrixartigen Aufbau mit Reihen und Spalten aufweist.

Vorzugsweise kann ein Bauteilsatz auch eine Menge von Bauteilen bedeuten, wobei von jedem Bauteil eine gewisse Stückzahl lieferbar ist. Die Abmessungen dieser Bauteile sind anbieterseitig festgelegt und müssen daher nicht individuell auf die jeweilige Einbausituation abgestimmt werden. In der Regel ist dann eine gewisse Stückzahl von jedem Bauteil anbieterseitig vorgefertigt und auf Lager gehalten.

Ein einheitlicher Einschubrahmen ist ein solcher, bei dem sämtliche Rahmenteile in Verbindung mit dem Einschubrahmen stehen und der den bei einem Flugzeug auftretenden Belastungsanforderungen entspricht. Der gesamte Einschubrahmen soll daher auch im vollständig beschickten Zustand bspw. Beschleunigungen von bis zu 10 g problemlos überstehen.

Die Einrichtung eines Einschubfachs zum "unabhängigen Einschieben bzw. Ausziehen" einer Elektronikeinheit bedeutet, daß ein Auswechseln einer Elektronikeinheit ohne Beeinflussung oder Beeinträchtigung des Einschubrahmens und/oder weiterer ggf. eingeschobener Elektronikeinheiten erfolgen kann. Dies bedeutet notwendigerweise, daß eine Elektronikeinheit oder Teile einer solchen nicht Teil des Einschubrahmens sein kann. Nur dadurch ist ein schnelles und unabhängiges Auswechseln beliebiger Elektronikeinheiten gewährleistet.

Die elektrische Versorgung einer in ein Einschubfach eingeschobenen Elektronikeinheit und die Signalübertragung von und zu der Elektronikeinheit erfolgt jeweils über einen ersten und einen zweiten zum Zusammenwirken miteinander eingerichtete Steckverbinder. Der zweite Steckverbinder ist jeweils an der Elektronikeinheit angeordnet, während der erste Steckverbinder rückseitig mit den entsprechenden Versorgungsund/oder Signalleitungen verbunden ist. Das Merkmal, daß das Zusammenwirken einander entsprechender erster und zweiter Steckverbinder allein infolge des Einschiebens der Elektronikeinheit in das Einschubfach bewirkbar ist, bedeutet, daß der elektrische Kontakt beim Einschieben automatisch hergestellt wird, ohne daß es eines zusätzlichen Handgriffs bedarf. Dies kann bspw. dadurch bewirkt werden, daß der zweite Steckverbinder relativ zum Einschubfach räumlich fixiert ist, und zwar mit entgegen der Einschubrichtung orientierter Steckeröffnung. Die räumliche Fixierung setzt den Kräften, die auf den zweiten Steckverbinder infolge des Einschiebens wirken, ausreichend Widerstand entgegen. Vorzugsweise sind die Steckverbinder so gestaltet, daß dieser Widerstand gering ist (low or zero insertion force). Vorzugsweise weisen die Steckverbinder miteinander zusammenwirkende Führungsflächen auf, die das Einschieben erleichtern.

"Im wesentlichen flach" bedeutet, daß die Rahmenteile im Mittel in einer Raumrichtung eine mindestens um den Faktor 3, vorzugsweise mindestens 5, weiter vorzugsweise mindestens 7 geringere Ausdehnung aufweisen als in den beiden übrigen Raumrichtungen. Auf die spezifische Form eines Rahmenteils kommt es dabei nicht an. Für die Seiten- und/oder Rückenteile beträgt der genannte Faktor weiter vorzugsweise mindestens 10, weiter vorzugsweise mindestens 20. Insbesondere die L-förmigen Trays des Standes der Technik sind nicht flach im genannten Sinne. Flache Rahmenteile sind bspw. hinsichtlich Lagerhaltung vorteilhaft.

Das Merkmal, daß die Breite eines Rahmenteils jeweils der Breite eines Einschubfachs entspricht, ist nicht so zu verstehen, daß die Breite des Rahmenteils exakt gleich der Breite des entsprechenden Einschubfachs sein muß. Das Merkmal bedeutet lediglich, daß sich die Rahmenteile in ihrer Breite nicht über im wesentlichen jeweils zwei oder mehr Einschubfächer erstrecken.

Die Erfindung hat erkannt, daß die Zergliederung jeweils einer Reihe von Einschubfächern in Rahmenteile, deren Breite jeweils an die kleinste vorgesehene Einheit, nämlich ein Einschubfach, angepaßt ist, eine erhöhte Flexibilität bei gleichzeitig verringerter Teileanzahl gewährleistet. Insbesondere können Einschubrahmen mit jeweils einer gewünschten Anzahl von nebeneinander liegenden Einschubfächern pro Reihe und/oder mit jeweils beliebig breiten Reihen gebildet werden.

Die Reduzierung der Anzahl unterschiedlicher Teile, die zur Bildung eines erfindungsgemäßen Einschubrahmens vorzuhalten sind, folgt daraus, daß für Rahmenteile einer bestimmten Höhe und Tiefe im wesentlichen lediglich eine der Zahl der standardisierten Breiten der Einschubfächer entsprechende Sortenzahl von Boden-, Decken- und Rückenteilen sowie eine einzige Sorte von Seitenteilen vorgesehen sein muß. Aufgrund der Erfindung wird der Aufwand für Herstellung und Lagerhaltung der entsprechenden Rahmenteile verringert. Im Vergleich dazu müssen im Stand der Technik eine Vielzahl von Teilen vorgesehen sein, die einerseits sowohl an den jeweiligen Flugzeugtyp und für jeden Flugzeugtyp an den jeweiligen Einbauort angepaßt sind. Die für einen Flugzeugtyp und für einen spezifischen Einbauort vorgesehenen Teile können in der Regel nicht für einen anderen Einbauort oder gar einen anderen Flugzeugtyp verwendet werden.

Erfindungsgemäß müssen nicht sämtliche der entsprechenden Rahmenteile das Merkmal erfüllen, daß ihre Breite jeweils der Breite eines Einschubfachs entspricht. Es kann zweckmäßig sein, Rahmenteile einer größeren Breite vorzusehen, um die rationale Erstellung von Einschubrahmen größerer Breiten zu ermöglichen. Vorzugsweise gilt Merkmal c) des Anspruchs 1 für mindestens 60 %, weiter vorzugsweise mindestens 80 %, weiter vorzugsweise sämtliche der entsprechenden Rahmenteile eines erfindungsgemäßen Bauteilsatzes.

Nach einem weiteren Merkmal der Erfindung entspricht die Höhe mindestens eines Teils der Rückenteile jeweils der Höhe eines Einschubfachs und sind die Rückenteile jeweils zur Verbindung mit dem oder den entsprechenden ersten Steckverbindern eingerichtet. Dies führt dazu, daß die ersten Steckverbinder im Betriebszustand ohne Zwischenteile mit dem Einschubrahmen verbunden sind. Gegenüber dem Stand der Technik bedeutet dies, daß auf separate Zwischenstücke wie die L-förmigen Trays verzichtet werden kann. Ein separates Zwischenstück zwischen Einschubrahmen und erstem elektrischen Steckverbinder ist im Stand der Technik notwendig, damit ein einzelner erster Steckverbinder unabhängig vom Einschubrahmen ausgetauscht werden kann. Diese Austauschbarkeit ergibt sich im Rahmen der Erfindung aus der dem jeweiligen Einschubfach entsprechenden Höhe der Rückenteile. Zum Auswechseln eines ersten Steckverbinders kann einfach das dem Einschubfach entsprechende Rückenteil unabhängig von den übrigen ersten Steckverbindern entfernt werden.

Eine weitergehende Flexibilisierung und Rationalisierung wird erreicht, wenn vorzugsweise die Höhe mindestens eines Teils der Seitenteile jeweils der Höhe eines Einschubfachs entspricht. Dieses Merkmal ermöglicht die Erstellung eines Einschubrahmens mit einer beliebigen Zahl von Reihen mit jeweils einer beliebigen Anzahl von nebeneinanderliegenden Einschubfächern pro Reihe. Im Ergebnis führt dies zu einem modularen Aufbau des Einschubrahmens, dessen Breite und Höhe individuell an die jeweiligen Gegebenheiten anpaßbar ist.

Die vorstehend in Bezug auf Merkmal c) des Anspruchs 1 gemachten Ausführungen gelten sinngemäß auch für Merkmal d) des Anspruchs 1 und für das Merkmal des Anspruchs 2.

Vorzugsweise sind die Rahmenteile zur lösbaren Verbindung miteinander eingerichtet. Es handelt sich also um solche Verbindungen, die ohne Beeinträchtigung der Rahmenteile wieder lösbar sind, ohne daß anschließend bspw. eines Säuberung der Rahmenteile erforderlich wäre. Dies kann bspw. mit Hilfe von Schraubverbindungen geschehen. Dagegen sind Klebverbindungen nicht von dieser vorteilhaften Ausführungsform umfaßt. Wenn die Verbindungen der Rahmenteile lösbar sind, kann ein Einschubrahmen demontiert und an anderer Stelle eingebaut werden. Allgemeiner gesagt kann jederzeit eine Anpassung an sich ändernde räumliche Bedingungen erfolgen.

Eine vorteilhafte Weiterbildung der Erfindung betrifft die Kühlung von in den Einschubrahmen eingeschobenen Elektronikeinheiten mit Hilfe eines Kühlmittel-, insbesondere Kühlluftstroms. Wenn nachfolgend von Kühlluft die Rede ist, sollen von diesem Begriff andere fluide, insbesondere gasförmige Kühlmittel mit umfaßt sein. Demnach sind vorteilhafterweise vollständig in die den Einschubrahmen bildenden Rahmenteile integrierte Kühlluftkammern vorgesehen, die jeweils eine oder mehrere in den Innenraum eines Einschubfachs gerichtete Kühlluftöffnungen aufweisen. Aufgrund der vollständigen Integration der Kühlluftkammern in die den Einschubrahmen bildenden Rahmenteile sind innerhalb des Einschubrahmens keine separaten Kühlluftleitungen erforderlich. Zweckmäßigerweise ist eine Kühlluftkammer zur Verbindung mit Kühlluftleitungen eingerichtet, die in Verbindung mit einer entsprechenden Kühlmittelquelle stehen.

Es ist besonders vorteilhaft, wenn die flächige Erstreckung einer Kühlluftkammer höchstens etwa den Abmessungen eines entsprechenden Einschubfachs entspricht. Diese Ausführungsform entspricht dem Grundgedanken der Modularität des Einschubrahmens. Es ist daher bspw. möglich, ein Einschubfach zu entfernen, ohne daß dadurch die Kühlung der übrigen Einschubfächer beeinträchtigt wird. Dies wäre der Fall, wenn sich eine Kühlluftkammer über zwei oder mehrere Einschubfächer erstreckt, so daß die Entfernung eines Einschubfachs die Versorgung benachbarter Einschubfächer unterbrechen könnte. Zweckmäßigerweise ist eine Kühlluftkammer demnach jeweils in ein einzelnes Rahmenteil integriert. Dabei handelt es sich vorzugsweise um ein Boden- und/oder Deckenteil.

Vorteilhafterweise sind einem Einschubfach neben mindestens einer Drucköffnung zur Kühlluftzufuhr auch mindestens eine Saugöffnung zur Abluftabsaugung zugeordnet, damit erwärmtes Kühlmittel nicht im Bereich des Einschubrahmens verbleibt, was der Kühlung insgesamt abträglich sein kann. Zweckmäßigerweise ist eine Abluftkammer zur Verbindung mit Abluftleitungen eingerichtet, die in Verbindung mit Einrichtungen zur Unterdruckerzeugung stehen. Die Abluftkammer bezeichnet eine mit einer Saugöffnung versehene Kühlluftkammer, die Zuluftkammer entsprechend eine mit einer Drucköffnung versehene Kühlluftkammer. Die Zuluft- und Abluftleitungen sind vorzugsweise in einem geschlossenen Kreislauf verbunden, welcher an die im Flugzeug vorhandenen Kühlsysteme angeschlossen werden kann. Eine beispielsweise verwendbare Form der Kühlung besteht darin, daß ein Teil des Kühlluftkreislaufs an der im Flugbetrieb kalten Außenhaut des Flugzeugs entlang geführt wird.

Vorteilhafterweise sind Druck- und Saugöffnung bezogen auf das jeweilige Einschubfach einander gegenüberliegend angeordnet, bspw. jeweils im entsprechenden Boden- und Deckenteil, um einen gleichförmig gerichteten Kühlmittelstrom zu bewirken.

Vorzugsweise ist für eine Kühl luftöffnung eine Regulierplatte (metering plate) zur Regulierung des Kühlluftdurchflusses vorgesehen. Zweckmäßigerweise ist eine Regulierplatte dichtend mit der entsprechenden Kühlluftkammer bzw. deren zum Innenraum des Einschubfaches weisenden Öffnung verbunden. Die Regulierplatte weist Reguliereinrichtungen auf. Dabei kann es sich einfach um Öffnungen eines bestimmten Durchmessers in der Regulierplatte handeln. Sämtliche Zuluftkammern können dann mit einem einheitlichen, ausreichend hohen Druck beaufschlagt sein; die jeweils für ein Einschubfach gewünschten Kühlluftdurchflüsse können individuell mit Hilfe der entsprechenden Regulierplatte eingestellt werden. Vorteilhafterweise sind dazu Verschließelemente, bspw. Gummistopfen vorgesehen, die zum Verschluß bzw. Öffnen einer den jeweiligen Bedürfnissen angepaßten Zahl von in der Regulierplatte vorgesehenen Regulieröffnungen (diese Regulieröffnungen sollen in der Regel mit entsprechenden Kühlmittelöffnungen im Gehäuse einer eingeschobenen LRU fluchten) dienen. Es müssen dann nicht jeweils Regulierplatten mit einer unterschiedlichen Anzahl von Regulieröffnungen vorgesehen sein, was zur Reduzierung der Teilezahl beiträgt.

Bevorzugt sind für zwei einander gegenüberliegende Zu- und Abluftöffnungen eines Einschubfachs einander entsprechende Regulierplatten versehen. Dies ist hilfreich für die Erzeugung eines gerichteten, gleichförmigen Kühlluftstroms.

Die Patentansprüche 1 bis 12 betreffen einen erfindungsgemäßen Satz von Bauteilen. Soweit in diesen Ansprüchen technische Merkmale enthalten sind, die sich auf den Einschubrahmen im zusammengesetzten Zustand beziehen, erfüllt ein Bauteilsatz diese Anspruchsmerkmale, wenn sie nach bestimmungsgemäßen Zusammenbau des Bauteilsatzes eintreten. Gegenstand der Erfindung ist ferner ein durch Zusammenbau eines erfindungsgemäßen Bauteilsatzes erhältlicher Einschubrahmen.

Die Erfindung wird im folgenden anhand vorteilhafter Ausführungsbeispiele mit Bezug auf die beigefügten Figuren erläutert. Es zeigen:
- Fig. 1:: Perspektivische Ansicht eines ersten Einschubrahmens gemäß der Erfindung,
- Fig. 2:: Ansicht des Einschubrahmens aus Fig. 1 von vorne,
- Fig. 3:: Ansicht des Einschubrahmens aus Fig. 1 von rechts,
- Fig. 4:: Ansicht A-A des Einschubrahmens aus Fig. 2,
- Fig. 5:: Ansicht B-B des Einschubrahmens aus Fig. 2,
- Fig. 6:: Perspektivische Ansicht eines zweiten Einschubrahmens gemäß der Erfindung,
- Fig. 7:: Perspektivische Ansicht eines dritten Einschubrahmens gemäß der Erfindung,
- Fig. 8:: Perspektivische Ansicht eines vierten Einschubrahmens gemäß der Erfindung,
- Fig. 9:: Ansicht A-A des Einschubrahmens aus Fig. 8,
- Fig. 10:: Perspektivische Ansicht eines fünften Einschubrahmens gemäß der Erfindung.

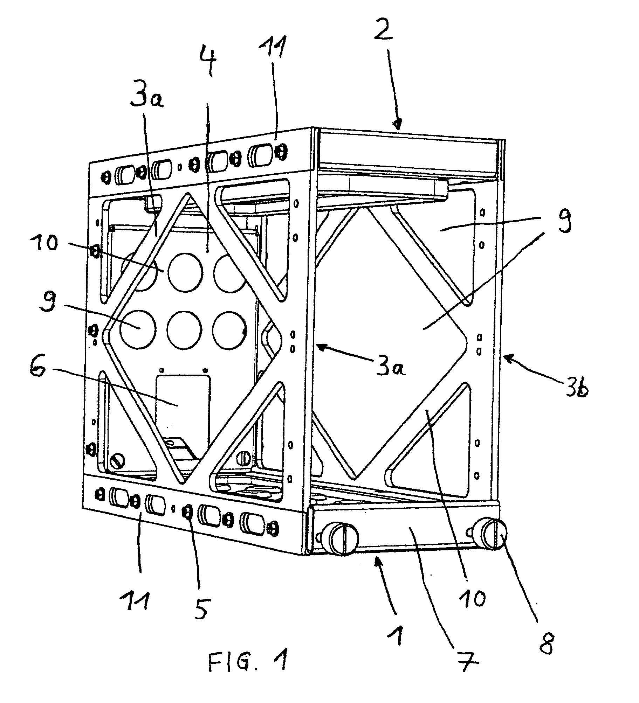

Der in Fig. 1 gezeigte Einschubrahmen besteht aus einem einzigen Einschubfach und wird von einem Bodenteil 1, einem Dekkenteil 2, zwei Seitenteilen 3a, 3b und einem Rückenteil 4 gebildet. Die Rahmenteile 1, 2, 3, 4 sind mit Hilfe von Schrauben 5 lösbar miteinander verbunden. Die miteinander verbundenen Rahmenteile 1, 2, 3, 4 bilden ein Einschubfach, in das von vorne eine Elektronikeinheit der Standardbreite 1/2 ATR (4 MCU) einschiebbar ist. Die Rückwand 4 weist an geeigneter Stelle eine Öffnung 6 auf, die zur Aufnahme eines elektrischen Adapters eingerichtet ist. Der eingesetzte Adapter wird fest mit der Rückwand 4 verbunden. Auf der Vorderseite der Rückwand 4, also der zum Einschubfach hin orientierten Seite, bildet der nicht in den Figuren gezeigte Adapter einen ersten elektrischen Steckverbinder. Eine in das Einschubfach einzuschiebende Elektronikeinheit weist an entsprechender Stelle einen zweiten elektrischen Steckverbinder auf. Beim Einschieben des Einschubs wird der zweiter Steckverbinder in den ersten Steckverbinder geführt, so daß beide Steckverbinder im eingeschobenen Zustand elektrisch in Kontakt sind. Auf der dem Einschubfach abgewandten Seite bildet der Adapter wiederum einen elektrischen Steckverbinder, der mit einem entsprechendem, mit elektrischen Versorgungsund/oder Signalleitungen verbundenen Steckverbinder zusammenwirkt.

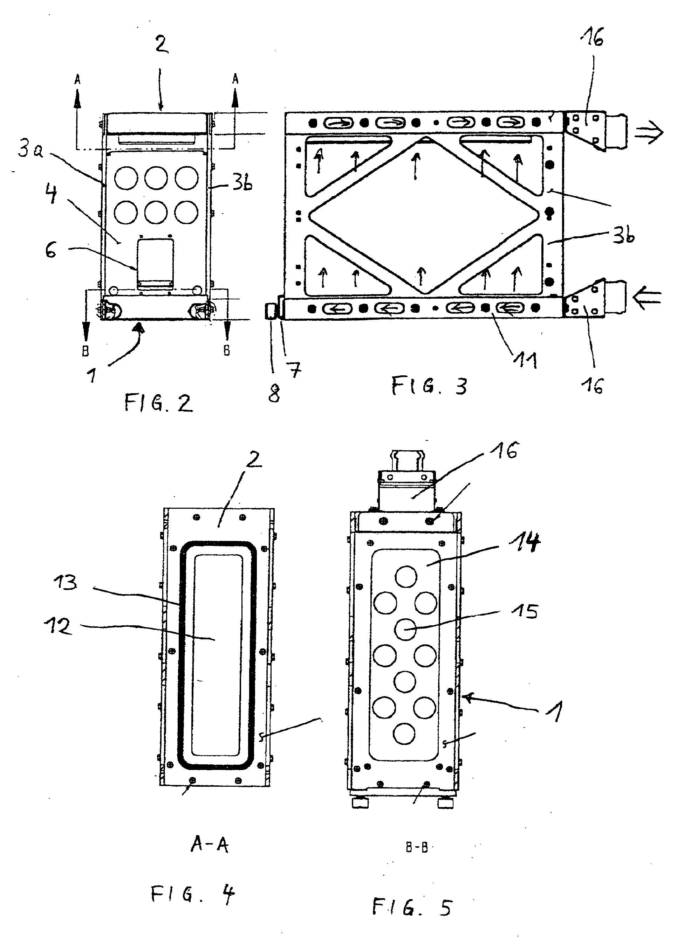

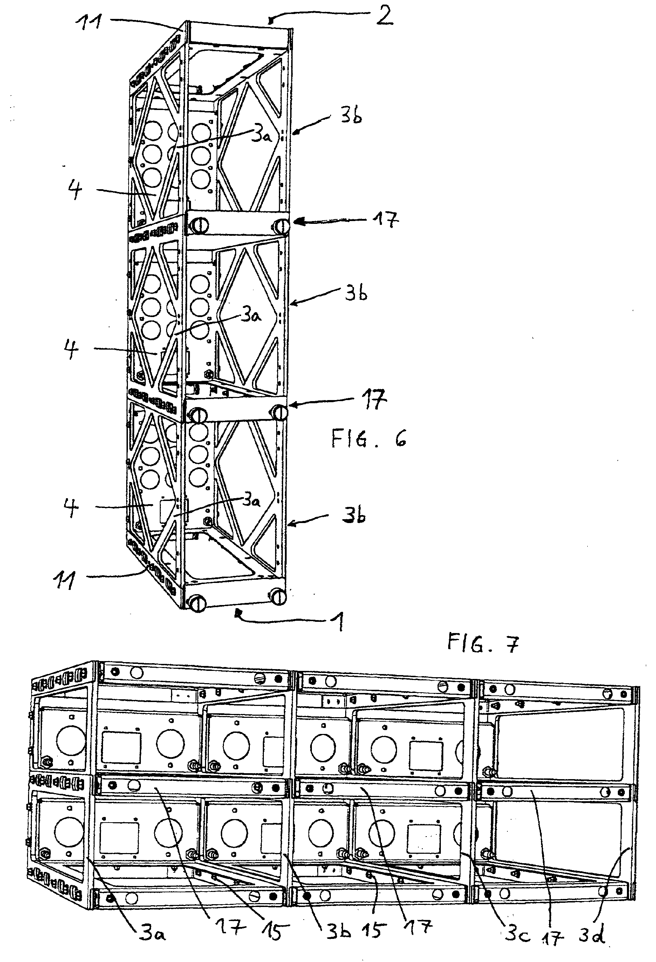

Ein eingeschobener Einschub wird mit Hilfe einer sich im wesentlichen über die Breite des Einschubfachs erstreckenden Lippe 7 festgesetzt, die in dem in Fig. 1 gezeigten arretierten Zustand nach oben über die Unterseite des Einschubfachs hinausragt, so daß eine Bewegung des Einschubs entgegen der Einschubrichtung durch Anschlag an der Lippe 7 verhindert wird. Die Lippe 7 wird mit Hilfe zweier Schrauben 8 festgesetzt. Zum Lösen der Arretierung werden die Schrauben 8 gelöst, woraufhin die Lippe 7 nach unten abgeklappt werden kann; in diesem geöffneten Zustand werden die Lippe 7 und die Schrauben 8 unverlierbar am Einschubrahmen gehalten. Die beschriebene Konstruktion, insbesondere die Verwendung einer flachen Haltelippe 7, ermöglicht eine gegenüber dem Stand der Technik verringerte Bautiefe (s. Fig. 3, 5). Da die Arretierungseinrichtung 7, 8 nicht mehr so weit hervorsteht, ergibt sich insgesamt ein verringerter Platzbedarf.

Die Rahmenteile, insbesondere die Seitenteile 3a, 3b und das Rückenteil 4, weisen Installationsöffnungen 9 auf. An den entsprechenden Stegen 10 können bspw. Kabel oder Führungseinrichtungen befestigt werden.

Die Leisten 11 dienen zum Ausfüllen entsprechender Nuten der Seitenteile 3a, 3b, deren Funktion später erläutert wird.

Sämtliche Bauteile sind gewichtsoptimiert. Bspw. bestehen die Rahmenteile 1, 2, 3, 4, 7, 11 vorzugsweise aus Aluminium bzw. einer Aluminiumlegierung.

Die Kühlung wird im folgenden insbesondere unter Bezugnahme auf die Figuren 2 bis 5 erläutert. Das Deckenteil 2 schließt eine Hohlkammer ein, die sich etwa über die Ausdehnung der Deckenplatte 2 erstreckt. Sie weist eine nach unten, also zum Einschubfach hin gerichtete Kühlluftöffnung 12 mit einer Dichtung 13 auf. Zur Abdeckung der Öffnung 12 ist an der Unterseite des Deckenteils 2 eine Durchflußregulierplatte (metering plate) 14 aufgesetzt und verschraubt. Die Regulierplatte 14 enthält Regulierungsöffnungen 15, hier kreisförmige Bohrungen. Einzelne Bohrungen 15 sind mit hier nicht gezeigten Gummistopfen verschließbar, um eine gezielte Regulierung des Luftstroms zu ermöglichen.

Entsprechendes gilt sinngemäß für das Bodenteil 1. Auch dieses weist vorzugsweise eine dichtend aufgesetzte Durchflußregulierplatte 14 auf. Die Öffnung 12 ist in diesem Fall nach oben gerichtet.

Bodenteil 1 und Deckenteil 2 weisen an ihrer Rückseite eine Öffnung auf, die jeweils mit einem Anschlußstück 16 vorzugsweise dichtend verbunden ist. An ihrem dem Einschubrahmen abgewandten Ende ist das Anschlußstück 16 zur Verbindung mit nicht gezeigten Leitungen, bspw. Schläuchen, zur Zufuhr bzw. Abfuhr von Kühlluft eingerichtet. Kühlluft wird über das dem Bodenteil 1 zugeordnete Anschlußstück 16 in die Kühlluftkammer des Bodenteils 1 eingeleitet und strömt durch die Öffnung 12 bzw. die Regulierungsöffnungen 15 in das Innere des Einschubfachs. Die Kühlluft durchströmt eine ggf. in das Einschubfach eingeschobene Elektronikeinheit. Das dem Deckenteil 2 zugeordnete Anschlußstück 16 wird an seinem dem Einschubfach abgewandten Ende mit Unterdruck beaufschlagt, so daß die aus einer ggf. eingeschobenen Elektronikeinheit austretende erwärmte Abluft durch die entsprechende Öffnung 12 bzw. die Regulierungsöffnungen 15 in die Kühlluftkammer des Deckenteils 2 und von dort durch das Anschlußstück 16 abgesaugt wird. Die dem Bodenteil 1 und dem Deckenteil 2 zugeordneten Anschlußstücke 16 sind vorzugsweise im Sinne eines Kühlluftkreislaufs verbunden, der an die jeweils in den Flugzeugen vorhandenen Kühlsysteme angeschlossen werden kann, um dort eine Kühlung der Kühlluft zu bewirken. Beispielsweise kann der Kühlkreislauf teilweise an der Außenhaut des Flugzeugs entlang geführt sein. Die Anschlußstücke 16 sind vorzugsweise universell an einem beliebigen Boden- und/oder Deckenteil verwendbar. In diesem Fall existiert nur eine einzige Sorte von Anschlußstücken 16, was die Teilevielfalt weiter reduziert. Die Anschlußstücke 16 sind insbesondere an einer Seite so abgeflacht gestaltet, daß sie in dem mit einem Boden- oder Deckenteil verbundenen Zustand mit dessen Außenseite fluchten oder jedenfalls nicht darüber hinaus vorstehen. Bei mehreren übereinanderliegenden Einschubfächern wird auf diese Weise eine Kollision der Anschlußstücke 16 miteinander vermieden (s. Fig. 9).

In Fig. 6 ist ein Einschubrahmen mit drei übereinander angeordneten Einschubfächern für Einschübe jeweils der Breite 1/2 ATR (4 MCU) gezeigt. Die Seitenteile 3a, 3b sind zur Verbindung miteinander in der Art von Nut-/Federverbindungen eingerichtet. Zu diesem Zweck besitzen sie an ihren oberen und unteren Enden sich über ihre gesamte Länge erstreckende Nuten. Die Nuten greifen wechselseitig ineinander, wobei bspw. bei dem mittleren Seitenteil 3a in Fig. 6 die Nuten nach innen, bei dem oberen und unteren Seitenteil 3a dagegen nach außen weisen. Aufgrund dieser Gestaltung genügt im vorliegenden Ausführungsbeispiel eine einzige Sorte von Seitenteilen 3a, 3b. Am oberen und unteren Ende des Einschubrahmens sind die Nuten der Seitenteile 3a, 3b mit Leisten 11 verschlossen. In der Ausführungsform gemäß Fig. 6 bildet bspw. das Deckenteil des unteren Einschubfachs gleichzeitig das Bodenteil des mittleren Einschubfachs. Dieses Zwischenteil 17 ist demnach sowohl dem unteren als auch dem mittleren Einschubfach zugeordnet und besitzt dementsprechend sowohl eine nach unten als auch eine nach oben gerichtete Kühlluftöffnung 12. Beide Kühlluftöffnungen 12 sind vorzugsweise mit Durchflußregulierplatten 14 versehen. Das Zwischenteil 17 ist an seiner Rückseite zur Verbindung mit lediglich einem Anschlußstück 16 eingerichtet. Das Kühlschema kann in Fig. 6 bspw. wie folgt aussehen. In das Bodenteil des unteren Einschubfachs wird ein Kühlluftstrom vom Betrag j eingeleitet. Aus dem darüberliegenden Zwischenboden 17 wird ein Abluftstrom vom Betrag 2j abgesaugt. In den darüberliegenden Zwischenboden wird ein Kühlluftstrom vom Betrag 2j eingeleitet. Aus dem Deckenteil 2 des oberen Einschubfachs wird ein Abluftstrom vom Betrag j abgesaugt. Auf diese Weise wird ein einheitlicher Luftstrom des Betrags j durch sämtliche Einschubfächer bewirkt. Mit Hilfe der bereits erwähnten Verschlußstopfen für die Regulieröffnungen 15 kann für jedes Einschubfach individuell der gewünschte Kühlluftstrom eingestellt werden.

Die Verwendung eines Zwischenbodens 17 anstelle eines separaten Bodenteils 1 und Deckenteils 2 führt zu einer insgesamt verringerten Bauhöhe.

Fig. 7 zeigt einen Einschubrahmen mit zwei Reihen von jeweils drei Einschubfächern für Videoeinheiten der Breite 3/4 ATR (6 MCU), die gegenüber der Höhe der Einschubfächer aus den Fig. 1, 6, 8 Unterhöhe aufweisen. Hinsichtlich der Nut-/ Federverbindung der Seitenteile sowie der Verwendung von Zwischenböden 17 gilt das zu Fig. 6 Gesagte entsprechend. Die mittleren Seitenteile 3b, 3c sind jeweils den rechts und links von ihnen liegenden Einschubfächern zugeordnet. Es ist daher nicht notwendig, für jedes Einschubfach zwei separate Seitenteile vorzusehen. Dies führt zu einem verringerten Aufwand und einer insgesamt reduzierten Breite. Die Rahmenteile 1, 2, 3, 4, 17 sind mit Hilfe von übergreifenden Schrauben oder Schraubbolzen 15 miteinander verbunden.

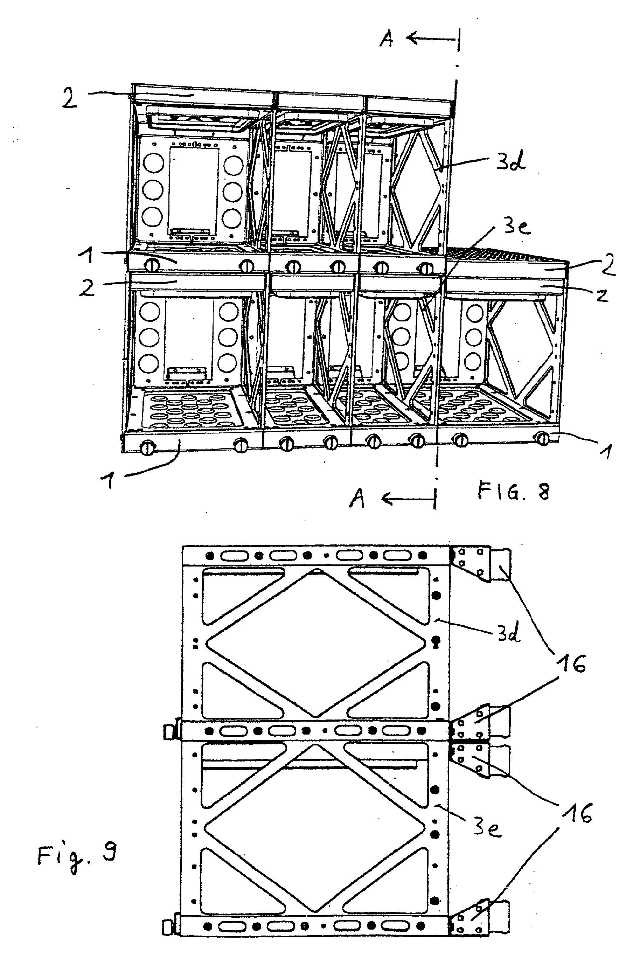

Fig. 8 zeigt einen Einschubrahmen mit einer unteren Reihe von vier Einschubfächern der Breiten sechs, vier, vier, sechs MCU und eine oben liegende Reihe von drei Einschubfächern der Breiten sechs, vier, vier MCU. Die Einschubfächer weisen dieselbe Höhe auf wie die der Fig. 1 und 6. Im Gegensatz zu den Ausführungsformen der Fig. 6, 7 sind hier für sämtliche Einschubfächer jeweils ein separater Bodenteil 1 und Deckenteil 2 vorgesehen. Die oberen Seitenteile 3d entsprechen den Seitenteilen der Ausführungsformen gemäß Fig. 1 und 6. Die unteren Seitenteile 3e weisen eine demgegenüber um die Höhe eines Bodenteils 1 vergrößerte Höhe auf. Sie erstrecken sich insoweit auch über den Bodenteil 1 eines der oberen Einschubfächer. Dennoch erfüllen sie die Eigenschaft, sich im wesentlichen nur über ein einzelnes (unteres) Einschubfach zu erstrecken. Zum Ausgleich der Überhöhe ist über dem Einschubfach rechts unten ein weiteres Deckenteil 2 vorgesehen.

Aus Fig. 9 ist ersichtlich, daß die einseitige Abflachung der Anschlußstücke 16 eine Kollision insbesondere der mittleren beiden Anschlußstücke vermieden wird.

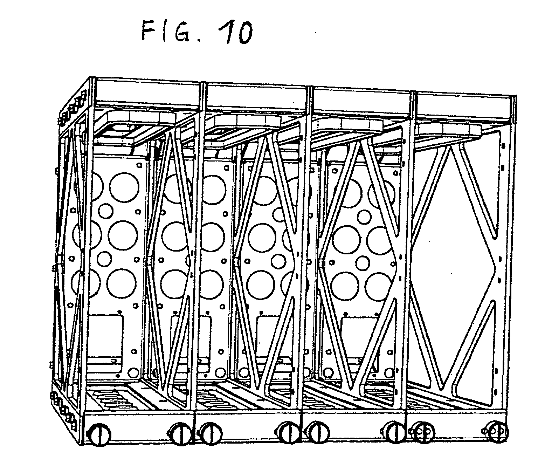

Fig. 10 zeigt einen Einschubrahmen mit einer Reihe von vier nebeneinanderliegenden Einschubfächern für Elektronikeinheiten der Breite 3/8 ATR (3 MCU) auf, die gegenüber den Einschubfächern der Einschubrahmen gemäß Fig. 1, 6 und 8 Überhöhe aufweisen.

Die gezeigten Ausführungsbeispiele betreffen solche Einschubrahmen, bei denen die Seitenteile jeweils eine von oben bis unten durchgehende Wand bilden. Dies soll keine Einschränkung darstellen. Im allgemeinen können die Seitenteile von Reihe zu Reihe beliebig zueinander versetzt angeordnet sein. Dagegen bilden die Decken- bzw. Bodenteile in der Regel durchgehende Reihen (shelf-Struktur); die Erfindung ist jedoch darauf ebenfalls nicht beschränkt.

## Patentansprüche

1. Satz von Bauteilen für einen Einschubrahmen für Flugzeuge, mit den Merkmalen:
a) der Satz von Bauteilen umfaßt im wesentlichen flache Rahmenteile, nämlich Bodenteile (1), Deckenteile (2), Seitenteile (3) und Rückenteile (4), und erste elektrische Steckverbinder,
b) die Rahmenteile (1, 2, 3, 4) sind so eingerichtet, daß sie sich zu einem einheitlichen Einschubrahmen verbinden lassen,
ba) der Einschubrahmen weist eine oder mehrere übereinander liegende Reihen mit jeweils einem oder mehreren nebeneinander liegenden Einschubfächern zur Aufnahme von Elektronikeinheiten auf,
baa) ein Einschubfach ist zum unabhängigen Einschieben bzw. Ausziehen einer Elektronikeinheit eingerichtet,
bab) einem Einschubfach ist jeweils ein erster elektrischer Steckverbinder so zugeordnet, daß ein Zusammenwirken des ersten Steckverbinders mit einem entsprechenden zweiten Steckverbinder einer Elektronikeinheit allein infolge des Einschiebens der Elektronikeinheit in das Einschubfach bewirkbar ist,
c) die Breite mindestens eines Teils der Bodenteile (1), Deckenteile (2) und/oder Rückenteile (4) entspricht jeweils der Breite eines Einschubfachs,
d) die Höhe mindestens eines Teils der Rückenteile (4) entspricht jeweils der Höhe eines Einschubfachs;
e) die Rückenteile (4) sind jeweils zur Verbindung mit dem oder den entsprechenden ersten Steckverbindern eingerichtet.

2. Satz von Bauteilen nach Anspruch 1, **dadurch gekennzeichnet, daß** die Höhe mindestens eines Teils der Seitenteile (3) jeweils der Höhe eines Einschubfachs entspricht.

3. Satz von Bauteilen nach Anspruch 1 oder 2, **dadurch gekennzeichnet, daß** die Rahmenteile (1, 2, 3, 4) zur lösbaren Verbindung miteinander eingerichtet sind.

4. Satz von Bauteilen nach einem der Ansprüche 1 bis 3, **dadurch gekennzeichnet, daß** die ersten Steckverbinder Teile von Adaptern sind.

5. Satz von Bauteilen nach einem der Ansprüche 1 bis 4, **dadurch gekennzeichnet, daß** vollständig in die den Einschubrahmen bildenden Rahmenteile (1, 2, 3, 4) integrierte Kühlluftkammern mit jeweils einer oder mehreren in den Innenraum eines Einschubfachs gerichteten Kühlluftöffnungen (12) vorgesehen sind.

6. Satz von Bauteilen nach Anspruch 5, **dadurch gekennzeichnet, daß** die flächige Erstreckung einer Kühlluftkammer (12) etwa den Abmessungen des entsprechenden Einschubfachs entspricht.

7. Satz von Bauteilen nach Anspruch 5 oder 6, **dadurch gekennzeichnet, daß** einem Einschubfach jeweils mindestens eine Kühlluft-Drucköffnung (12) und mindestens eine Kühlluft-Saugöffnung (12) zugeordnet ist.

8. Satz, von Bauteilen nach einem der Ansprüche 5 bis 7, **dadurch gekennzeichnet, daß** mindestens eine der einem Einschubfach zugeordneten Kühlluftöffnungen (12) mit einer Regulierplatte (14) versehen ist.

9. Satz von Bauteilen nach Anspruch 8, **dadurch gekennzeichnet, daß** die Regulierplatte (14) dichtend mit der Kühlluftöffnung (12) verbunden ist.

10. Satz von Bauteilen nach Anspruch 8 oder 9, **dadurch gekennzeichnet, daß** Verschließelemente vorgesehen sind, mit denen eine gewünschte Anzahl von in der Regulierplatte (14) vorgesehenen Regulieröffnungen (15) verschließbar ist.

11. Satz von Bauteilen nach einem der Ansprüche 1 bis 10, **dadurch gekennzeichnet, daß** die Seitenteile (3) zur Nut-/Feder-Verbindung miteinander eingerichtet sind.

12. Satz von Bauteilen nach einem der Ansprüche 1 bis 12, **dadurch gekennzeichnet, daß** die Einschubfächer jeweils eine Breite aufweisen, die einer der folgenden Standardbreiten entspricht:
| **Breite** | | **Breite [mm]** | | **Breite [inches]** | |
|---|---|---|---|---|---|
| **[ATR]** | **[MCU]** | **Minimum** | **Maximum** | **Minimum** | **Maximum** |
| 1/8 | 1 | 25.15 | 25.65 | 0.990 | 1.010 |
| 1/4 | 2 | 56.64 | 57.66 | 2.230 | 2.270 |
| 3/8 | 3 | 89.92 | 90.94 | 3.540 | 3.580 |
| 1/2 | 4 | 123.44 | 124.46 | 4.860 | 4.900 |
| 5/8 | 5 | 156.72 | 157.74 | 6.170 | 6.210 |
| 3/4 | 6 | 190.00 | 191.02 | 7.480 | 7.520 |
| 7/8 | 7 | 222.76 | 223.78 | 8.770 | 8.810 |
| 1 | 8 | 255.78 | 256.80 | 10.070 | 10.110 |
| 1/8 | 9 | 288.80 | 289.82 | 11.370 | 11.410 |
| 1 1/4 | 10 | 321.82 | 322.84 | 12.670 | 12.710 |
| 1 3/8 | 11 | 354.84 | 355.86 | 13.970 | 14.010 |
| 1 1/2 | 12 | 387.86 | 388.88 | 15.270 | 15.310 |
| | | usw. | | | |

13. Einschubrahmen, erhältlich durch Zusammenbauen eines Satzes von Bauteilen nach einem der Ansprüche 1 bis 12.
